# EUROPÄISCHE PATENTSCHRIFT

(11) **EP 0 554 522 B1**
(45) Veröffentlichungstag und Bekanntmachung des Hinweises auf die Patenterteilung: **04.01.1995**
(21) Anmeldenummer: 92119075.7
(22) Anmeldetag: 06.11.1992
(51) Int. Cl.: C23C 14/56, C23C 14/50, C23C 14/24

(54) **Drehschleuse zum Ein- und/oder Ausbringen eines Substrats aus der einen in eine benachbarte Behandlungskammer**
Rotary lock for transferring a substrate from one treatment- chamber to a neighbouring one
Excluseur rotatif pour le transport d'un substrat d'une enceinte de traitement à une enceinte de traitement voisine

(30) Priorität: 07.02.1992 DE 4203473
(43) Veröffentlichungstag der Anmeldung: 11.08.1993
(73) Patentinhaber: LEYBOLD AKTIENGESELLSCHAFT, D-63450 Hanau (DE)
(72) Erfinder: Nähring, Herbert, W-6458 Rodenbach (DE)

(56) Entgegenhaltungen:
- EP-A- 0 389 820
- DE-C- 3 941 502

## Beschreibung

Die Erfindung betrifft eine Drehschleuse zum Ein- und/oder Ausbringen aus der einen in eine benachbarte Behandlungskammer oder aus dem atmosphärischen Raum in eine Kammer geringeren Drucks, insbesondere Schlitzschleuse für eine Durchlauf-Vakuumbeschichtungsanlage, mit einer torartigen, in ortsfesten Lagern gehaltenen Ventilplatte und einem mit dieser in Wirkverbindung stehenden Schließmotor und einem die Schleusenöffnung umschließenden rahmenförmigen Dichtelement.

Durch die DE-OS 39 41 502 ist eine Beschickungs- bzw. Entleerungskammervorrichtung bekannt, mit einer Unterdruckkammer, einem innerhalb der betreffenden Unterdruckkammer versehenen Transportmechanismus für den Transport eines Substrathalters in Plattenform, der geeignet ist für die lösbare Anbringung von Substraten, mit einem Abführanschluß zum Evakuieren der Kammer auf einen Unterdruck und mit einem Gaseinlaßanschluß für die Einführung eines Gases, um die evakuierte Kammer auf einen atmosphärischen Druck zurückzuführen.

Bei dieser vorbekannten Vorrichtung ist beiderseits der Unterdruckkammer ein Schleusenventil vorgesehen, bei dem die Ventilplatte eine längliche, parallelepipede Form aufweist, wobei die Ventilplatte mit jeweils drei Lagerböcken fest verbunden ist, durch die eine Achse hindurchgeführt ist, die ihrerseits wiederum mit Schwenkhebeln in Verbindung steht, die über einen Zahnstangentrieb mit Motor verschwenkbar sind. Die Ventilplatte ist gegenüber den um ortsfeste Lager bewegbaren Hebeln kippbar gehalten, so daß die Dichtfläche der Ventilplatte auf die Dichtfläche am Gehäuse der Unterdruckkammer anpreßbar ist, wobei die Ventilplatte nach der Ebene der Gehäusedichtfläche im bestimmten Umfange ausrichtbar ist.

In der Praxis hat sich nun gezeigt, daß die bekannte Ventileinrichtung bzw. das bekannte Schleusenventil höchsten Anforderungen an die Dichtheit insbesondere deshalb nicht entspricht, weil der notwendige Dichtring ungleichmäßig beansprucht wird, da sich die Dichtplatte bzw. die Antriebsachse während des Verschlußzustands in gewissem Umfang durchbiegen, insbesondere aber wenn die Schleusenplatte ein extremes Breiten/Längenverhältnis aufweist und wenn die einzelnen Teile des Schleusenventils nicht eine extreme Robustheit - und damit ein hohes Gewicht - und eine ausgesuchte Werkstoffqualität aufweist.

Der vorliegenden Erfindung liegt nun die Aufgabe zugrunde, eine Drehschleuse des in Frage stehenden Typs so auszubilden, daß über die ganze Länge der Ventilplatte eine gleichmäßige Schließkraft bzw. Anpreßkraft erzeugbar ist, daß im Wartungs- und Reparaturfall Druckstufe und Antriebseinheit problemlos auswechselbar sind (während die vergleichsweise sperrige und schwere Ventileinheit komplett montiert im Rezipienten verbleibt), und schließlich die Ventileinheit selbst so steif und gleichzeitig so leicht wie möglich auszubilden.

Diese Aufgabe wird erfindungsgemäß dadurch gelöst, daß die Ventilplatte an einem sich etwa parallel zu ihr erstreckenden Ventilbalken über mindestens ein elastisch verformbares Zwischenglied angelenkt ist, wobei der Ventilbalken zwei einander diametral gegenüberliegende Lagerzapfen aufweist, die drehfest mit den Wellen der im übrigen außerhalb der Kammer vorgesehenen Antriebsmotore gekuppelt sind, wozu die Wellen durch die Wand der Kammer druckfest hindurchgeführt sind.

Weitere bevorzugte Ausführungsformen sind in den Ansprüchen 2-5 näher beschrieben und gekennzeichnet.

Die Erfindung läßt die verschiedensten Ausführungsmöglichkeiten zu; eine davon ist in den anhängenden Zeichnungen näher dargestellt, und zwar zeigen:
- Fig. 1: den Längsschnitt durch ein Schleusenventil, wobei die Kammer zur Behandlung des Substrats selbst nur teilweise dargestellt ist,
- Fig. 2: den Schnitt gemäß den Linien A-A quer durch das Schleusenventil nach Figur 1,
- Fig. 3: den Schnitt gemäß den Linien B-B quer durch das Schleusenventil nach Figur 1 und
- Fig. 4: die Darstellung gemäß Figur 3, jedoch der besseren Erkennbarkeit von Einzelheiten wegen in größerem Maßstab.

Statt einer Ventilplattenwelle ist der Gegenstand der Erfindung mit einem biegesteifen Profil ausgestattet, das als Ventilbalken 1 bezeichnet ist. Der Ventilbalken 1 ist mit zwei Lagerzapfen 12, 12a versehen, die von den im Inneren des Rezipienten 3 gelegenen Lagergehäusen 11, 11a aufgenommen werden bzw. in diesen gelagert sind.

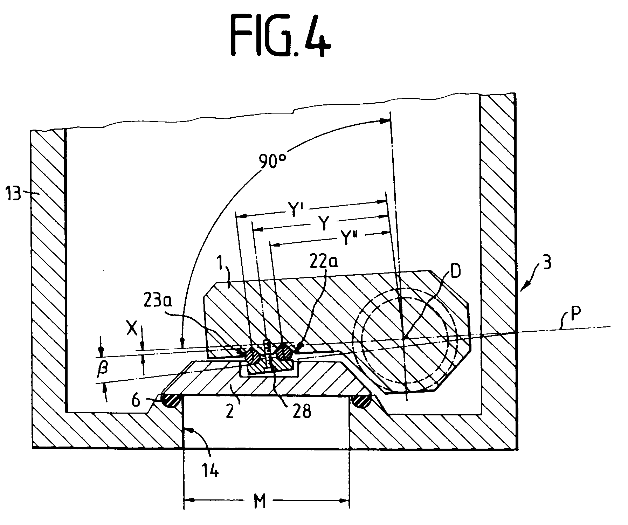

Die Dichtnut für den die Schleusenöffnung 14 abdichtenden Dichtring 6 befindet sich in der Dichtplatte 7. Da die Dicke der Ventilplatte 2 reduziert ist, ergibt sich eine Vergrößerung der Durchfahrbreite bzw. Schlitzbreite M (siehe Figur 4).

Die Befestigung der Ventilplatte 2 am Ventilbalken 1 mit Hilfe von zwei Federstäben 5, 5a stellt eine in zwei Achsen zueinander bewegliche, gelenk- und damit reibungsfreie Verbindung dar, mit der verhindert wird, daß die bei der Ventilbetätigung auftretenden Relativbewegungen Ventilplatte 2 / Ventilbalken 1 zueinander Gelenkreibung und damit Abriebpartikel erzeugen.

Die Federstäbe 5, 5a sind an Ventilplatte 2 und Ventilbalken 1 in der Weise angeordnet, daß sie mit Hilfe besonderer, mit Schrauben 28 am Ventilbalken 1 bzw. an der Ventilplatte 2 befestigter Klemmstücke 4, 4a, 4b, ... bzw. 24, 24a, ... in entsprechende V-förmig ausgefräste Nuten 16, 17 gedrückt werden. Diese V-Nuten 16, 17 bzw. 22, 23 sind so ausgebildet, daß bei ungespannten Federstäben 5, 5a die Ventilplatte 2 eine definiert nicht parallele Lage (Winkel α) zum Ventilbalken 1 einnimmt, so daß beim Schließvorgang die Ventilplattendichtfläche 23 sowohl auf den O-Ring 6 außen als auch auf den O-Ring innen zum gleichen Zeitpunkt aufsetzt. Die erwähnte nicht parallele Lage ergibt sich aus der ungleichen Tiefe (Maß X) der Nuten 22, 23 (siehe Figur 4) zur Ebene P.

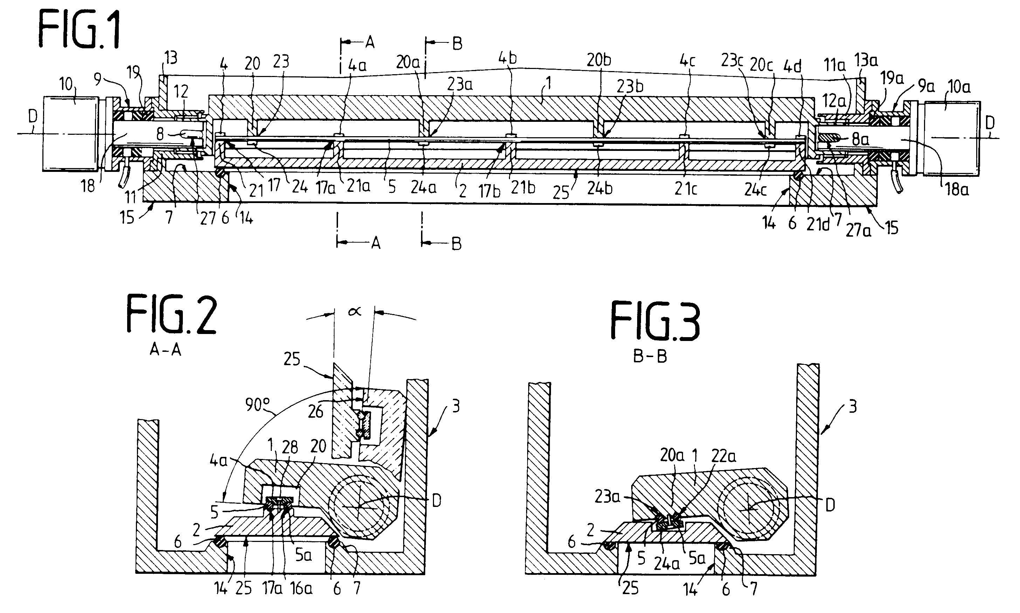

Im weiteren Verlauf des Schließvorgangs wandert die Dichtplatte 2 geradlinig weiter, unabhängig von den Befestigungsorten der Federstäbe 5, 5a am Ventilbalken 1, die eine Drehbewegung um die Lagerachse D ausführen, bis zur Beendigung des Anpreßvorgangs (Figur 3).

Da der von der Drehachse D aus gesehen weiter außen liegende Federstab 5 einen größeren Kreisbogen beschreibt als der innenliegende, ist auch seine Durchbiegung und damit seine Anpreßkraft kleiner als die des inneren Federstabs 5a, was zur Folge hat, daß die Anpressung der Dichtplatte 2 an den äußeren O-Ringstrang 6 ebenfalls kleiner ist als an den inneren. Dies wird korrigiert, indem die Federstab-Befestigungsnuten 22, 22a, ... um ein definiertes Maß X zur Schwenkebene P hin angeordnet sind, so daß die resultierende aus den Andrückkräften wieder mittig, also symmetrisch zu den O-Ringsträngen 6, angreift. Eine weitere Möglichkeit der Korrektur der Anpreßkräfte ergibt sich dadurch, daß die Nutenpaare in den Stegen 20, 20a, ... bzw. den Stegen 21, 21a, ... jeweils nicht zueinander fluchtend eingerichtet sind, sondern in ihrem Abstand Y zur Drehachse D geringfügig (z. B. 0,7 mm) variieren.

Um über die ganze Länge der Ventilplatte 2 eine möglichst gleichmäßige Anpreßkraft zu haben, wird das zur Ventilbetätigung erforderliche Drehmoment symmetrisch über beide Enden des Ventilbalkens 1 mittels zweier Pneumatik-Drehantriebe 10, 10a eingeleitet. Die verlängerten Wellen 18, 18a dieser Drehantriebe ragen durch die Druckstufen 9, 9a hindurch in den Rezipienten 3 hinein. Somit dichten die Dichtelemente 19, 19a, ... der Druckstufen 9, 9a auf den Antriebswellen 18, 18a ab, die keiner Biegebeanspruchung unterliegen. Eine Beeinträchtigung der Dichtwirkung durch Querversatz der Wellenachsen kann damit nicht auftreten.

Die Wellenenden der Antriebseinheiten sind als Gabeln ausgebildet, die sich bei der Montage der Drehantriebe 10, 10a über die in den Lagerzapfen (Hohlzapfen) 12, 12a des Ventilbalkens 1 fest montierten Querfedern 8, 8a schieben. Da die Querfedern 8, 8a senkrecht zur Dichtfläche stehen (nicht - wie zum besseren Verständnis gezeichnet - parallel zu dieser), findet bei der Durchbiegung des Ventilbalkens 1 keine Kantenpressung auf den Paßflächen der Querfeder-Antriebswellengabeln statt und somit auch keine Zusatzbeanspruchung der Antriebswellen 18, 18a.

Da Ventillagergehäuse und Druckstufengehäuse separat ausgebildet sind, können im Wartungs- bzw. Reparaturfall Druckstufe und Antriebseinheit problemlos gewechselt werden, während die eigentliche schwere Ventileinheit komplett montiert im Rezipienten 3 verbleiben kann.

Durch die beidseitige, d. h. symmetrische Einleitung des Drehmoments in das Betätigungsteil (dem Ventilbalken 1) sowie die in zwei Achsen gegenüber dem Ventilbalken 1 frei bewegliche Ventilplatte 2 wird eine weitgehend gleichmäßige Anpressung des Dichtrings 6 auf seinem ganzen Umfang erreicht, was insbesondere auch Fertigungsungenauigkeiten ausgleicht.

### Bezugszeichenliste

- 1: Ventilbalken
- 2: Ventilplatte
- 3: Rezipient (Vakuumkammer)
- 4, 4a,: Klemmstück (vorne)
- 5, 5a: Federstab
- 6: Dichtring
- 7: Dichtplatte
- 8, 8a: Querfeder
- 9, 9a: Druckstufe
- 10, 10a: Drehantrieb, Motor
- 11, 11a: Lagergehäuse
- 12, 12a: Lagerzapfen, Lagerhülse
- 13: Rezipientenwand, Kammerwand
- 14: Schleusenöffnung
- 15: Kammer
- 16: Nut
- 17, 17,: Nut
- 18, 18a: Welle
- 19, 19a: Dichtelement, Dichtring
- 20, 20a: Rippe
- 21, 21a: Rippe
- 22, 22a: Nut
- 23, 23a: Nut
- 24, 24a,: Klemmstück (hinten)
- 25: Verschlußfläche
- 26: Ventilbalkenfläche
- 27, 27a: Längsschlitz
- 28: Schraube

## Patentansprüche

1. Drehschleuse zum Ein- und/oder Ausbringen eines Substrats von der einen in eine benachbarte Behandlungskammer oder aus dem atmosphärischen Raum in eine Kammer geringeren Drucks, insbesondere Schlitzschleuse, für eine Durchlauf-Vakuumbeschichtungsanlage mit einer torartigen, in ortsfesten Lagern (11, 11a) gehaltenen Ventilplatte (2) und einem mit dieser in Wirkverbindung stehenden Schließmotor (10, 10a) und mit einem die Schleusenöffnung (14) umschließenden rahmenförmigen Dichtelement (6), **dadurch gekennzeichnet,** daß die Ventilplatte (2) an einem sich etwa parallel zu ihr erstreckenden Ventilbalken (1) über mindestens ein elastisch verformbares Zwischenglied (5, 5a) angelenkt ist, wobei der Ventilbalken (1) seinerseits zwei einander diametral gegenüberliegende Lagerzapfen (12, 12a) aufweist, die drehfest mit den Wellen (18, 18a) der Motore (10, 10a) gekuppelt sind, wobei die Wellen (18, 18a) der im übrigen außerhalb der Kammer (15) vorgesehenen Motore (10, 10a) durch die Wand (13, 13a) der Kammer (3) druckfest hindurchgeführt sind.

2. Drehschleuse nach Anspruch 1, **dadurch gekennzeichnet,** daß der Ventilbalken (1) eine Vielzahl von auf seiner Länge verteilt angeordnete Rippen (20, 20a, ...) aufweist, die jeweils über Klemmstücke (24, 24a, ...) mit einem Paar parallel zur Drehachse (D) der Wellen (18, 18a) angeordneten Bändern, Profilelementen oder Stäben (5, 5a) aus elastischem Werkstoff fest verbunden sind, wobei die beiden Stäbe (5, 5a) - parallel zueinander verlaufend - in Nuten (17, 17a, ... bzw. 16, 16a, ...) eingreifen, die auf der dem Ventilbalken (1) zugekehrten Seite der Ventilplatte (1) in Rippen (21, 21a, ...) vorgesehen sind, die sich in Abständen quer zur Drehachse (D) erstrecken, wobei die beiden Federstäbe (5, 5a) mit Hilfe von Klemmstücken (4, 4a, ...) fest mit diesen Rippen (21, 21a, ...) verbunden, beispielsweise verschraubt, sind.

3. Drehschleuse nach den Ansprüchen 1 und 2, **dadurch gekennzeichnet,** daß die in die Rippen (20, 20a, ...) des Ventilbalkens (1) eingeschnittenen Kerben oder Nuten (22, 22a, ... bzw. 23, 23a, ...) unterschiedlich tief zur Ebene (P) des Ventilbalkens (1) ausgebildet sind, wodurch die Ebene der Verschlußfläche (25) der Ventilplatte (2) gegenüber der Wirkebene (26) des Ventilbalkens (1) in der Offen-Position geringfügig gekippt ist.

4. Drehschleuse nach den vorhergehenden Ansprüche, **dadurch gekennzeichnet,** daß die Lagerzapfen (12, 12a) des Ventilbalkens (1) mit Längsbohrungen versehen sind, in die die Wellen (18, 18a) der Motore (10, 10a) eingreifen, wobei die ventilbalkenseitigen Enden der Wellen (18, 18a) jeweils mit einem Längsschlitz (27, 27a) versehen oder gabelförmig ausgebildet sind, wobei quer zur Drehachse (D) durch die Lagerzapfen (12, 12a) jeweils ein Keil oder eine Querfeder (8, 8a) hindurchgeführt ist und jeweils die Motorwelle (18, 18a) drehfest mit dem Ventilbalken (1) kuppelt.

5. Drehschleuse nach einem oder mehreren der vorhergehenden Ansprüche, **dadurch gekennzeichnet,** daß die in den im Abstand zueinander angeordneten Stegen 20, 20a, ... bzw. 21, 21a, ...) vorgesehenen Paare von Kerben oder Nuten (16, 17, ... bzw. 22, 23, ...) einen verschieden großen Abstand zur Drehachse (D) aufweisen.

## Claims

1. Rotary lock for removing a substrate from one treatment chamber and inserting it into an adjacent one or from the atmospheric space into a chamber with lower pressure, in particular a slotted lock, for a continuous vacuum coating system having a door-like valve plate (2) which is held in rigid bearings (11, 11a) and having a closure motor (10, 10a) which is operationally connected to said valve plate and having a frame-like sealing element (6) surrounding the lock opening (14), characterized in that the valve plate (2) is articulated by means of at least one resiliently deformable intermediate member (5, 5a) on a valve beam (1) extending approximately parallel to said valve plate, the valve beam (1) in turn comprising two diametrically opposite journals (12, 12a) which are coupled in a manner fixed for rotation with the shafts (18, 18a) of the motors (10, 10a), the shafts (18, 18a) of the motors (10, 10a) which are moreover provided externally of the chamber (15) being guided in compression-resistant manner through the wall (13, 13a) of the chamber (3).

2. Rotary lock according to Claim 1, characterized in that the valve beam (1) comprises a plurality of ribs (20, 20a, ...) which are distributed along its length and which are in each case rigidly connected by means of clamping parts (24, 24a, ...) to a pair of strips, profiled elements or rods (5, 5a) of resilient material disposed parallel to the axis of rotation (D) of the shafts (18, 18a), the two rods (5, 5a) - extending parallel to one another - engaging grooves (17, 17a, ... and 16, 16a, ... respectively) which are provided in ribs (21, 21a, ...) on the side, of the valve plate (1), facing the valve beam (1), which ribs extend at spacings transversely to the axis of rotation (D), the two spring rods (5, 5a) being rigidly connected, for example screwed, to these ribs (21, 21a, ...) by means of clamping parts (4, 4a, ...).

3. Rotary lock according to Claims 1 and 2, characterized in that the notches or grooves (22, 22a, ... and 23, 23a, ... respectively) cut into the ribs (20, 20a, ...) of the valve beam (1) are of different depths relative to the plane (P) of the valve beam (1), whereby the plane of the closure surface (25) of the valve plate (2) in the open position is tilted slightly relative to the operating plane (26) of the valve beam (1).

4. Rotary lock according to any one of the preceding claims, characterized in that the journals (12, 12a) of the valve beam (1) are provided with elongate bores in which the shafts (18, 18a) of the motors (10, 10a) engage, the ends, of the shafts (18, 18a), at the valve beam end in each case being provided with an elongate slot (27, 27a) or being fork-shaped, a wedge or transverse spring (8, 8a) being guided in each case transversely to the axis of rotation (D) through the journals (12, 12a) and coupling the motor shaft (18, 18a) in each case to the valve beam (1) in a manner fixed for rotation.

5. Rotary lock according to one or more of the preceding claims, characterized in that the pairs of notches or grooves (16, 17, ... and 22, 23, ... respectively) provided in the webs (20, 20a, ... and 21, 21a, ... respectively) disposed at a spacing from one another are at spacings of different sizes from the axis of rotation (D).

## Revendications

1. Ecluse rotative pour l'insertion et/ou l'extraction d'un substrat de l'une dans une autre chambre de traitement voisine, ou hors de l'enceinte atmosphérique dans une chambre sous pression réduite, en particulier écluse à fente, pour une installation de revêtement sous vide en continu, comportant une plaque de clapet (2) en forme de porte, maintenue dans des paliers fixes (11, 11a), et un moteur de fermeture (10, 10a) placé en liaison de travail avec celle-ci, ainsi qu'un élément d'étanchéité (6) en forme de cadre entourant l'ouverture d'écluse (14), caractérisée en ce que la plaque de clapet (2) est articulée par l'intermédiaire d'au moins un organe intermédiaire (5, 5a) élastiquement déformable sur une poutre de clapet (1) s'étendant sensiblement parallèlement à elle, la poutre de clapet (1) présentant de son côté deux pivots de palier (12, 12a) diamétralement opposés l'un à l'autre, qui sont accouplés à rotation solidaire avec les arbres (18, 18a) des moteurs (10, 10a), les arbres (18, 18a) des moteurs (10, 10a) prévus par ailleurs à l'extérieur de la chambre (15) étant guidés à travers les parois (13, 13a) de la chambre (3) de manière résistant à la pression.

2. Ecluse rotative selon la revendication 1, caractérisée en ce que la poutre de clapet (1) présente un grand nombre de nervures (20, 20a, ...) disposées de manière répartie suivant sa longueur, et qui sont reliées chacune fixement, par l'intermédiaire de pièces de serrage (24, 24a, ...) à une paire de bandes, d'éléments profilés ou de barreaux (5, 5a) en matériau élastique disposés parallèlement à l'axe de rotation (D) des arbres (18, 18a), les deux barreaux (5, 5a) s'étendant parallèlement l'un à l'autre s'insérant dans des rainures (17, 17a, ... et 16, 16a, ...) qui sont prévues dans des nervures (21, 21a, ...) sur le côté de la plaque de clapet (1) tournée vers la poutre de clapet (1), et qui s'étendent à distance transversalement par rapport à l'axe de rotation (D), les deux barreaux à ressort (5, 5a) étant reliés fixement à ces nervures (21, 21a, ...) à l'aide de pièces de serrage (4, 4a, ...), et par exemple vissés.

3. Ecluse rotative selon les revendications 1 et 2, caractérisée en ce que les entailles ou rainures (22, 22a, ... et 23, 23a, ...) découpées dans les nervures (20, 20a, ...) de la poutre de clapet (1) sont réalisées dans des profondeurs différentes par rapport au plan (P) de la poutre de clapet (1), grâce à quoi le plan de la surface de fermeture (25) de la plaque de clapet (2) est légèrement incliné par rapport au plan de travail (26) de la poutre de clapet (1) dans la position ouverte.

4. Ecluse rotative selon les revendications précédentes, caractérisée en ce que les pivots de palier (12, 12a) de la poutre de clapet (1) sont dotés d'alésages longitudinaux dans lesquels pénètrent les arbres (18, 18a) des moteurs (10, 10a), les extrémités, situées du côté de la poutre de clapet, des arbres (18, 18a) étant chacune dotée d'un fente longitudinale (27, 27a) ou sont configurées en forme de fourche, un biseau ou un ressort transversal (8, 8a) traversant les pivots de palier (12, 12a) transversalement par rapport à l'axe de rotation (D), et chaque arbre de moteur (18, 18a) étant accouplé à rotation solidaire à la poutre de clapet (1).

5. Ecluse rotative selon l'une ou plusieurs des revendications précédentes, caractérisée en ce que les traverses (20, 20a, ... et 21, 21a, ...) disposées à distance l'une de l'autre présentent des paires d'entailles ou de rainures (16, 17, ... et 22, 23, ...) à distance différente de l'axe de rotation (D).
